# EUROPEAN PATENT APPLICATION

(11) **EP 4 763 600 A1**
(43) Date of publication of application: **24.06.2026**
(21) Application number: 25181039.6
(22) Date of filing: 05.06.2025
(51) Int. Cl.: B60L 58/16, B60L 3/12, G01R 31/392

(54) **CLOUD-BASED SYSTEM AND METHOD FOR DIAGNOSING A BATTERY**

(30) Priority: 18.12.2024 KR 20240189557
(71) Applicant: Hyundai Motor Company, Seoul 06797 (KR); Kia Corporation, Seoul 06797 (KR)
(72) Inventor: CHOI, Yoon Sung, 18280 Hwaseong-si, Gyeonggido (KR); KIM, Jae Won, 18280 Hwaseong-si, Gyeonggido (KR); LEE, Hyo Kyung, 18280 Hwaseong-si, Gyeonggido (KR); JUNG, Chang Ho, 18280 Hwaseong-si, Gyeonggido (KR)
(74) Representative: Viering, Jentschura & Partner mbB Patent- und Rechtsanwälte

(57) **Abstract**

A cloud-based battery diagnostic system includes a communication device configured to collect data from a vehicle and transmit a battery status diagnostic result to the vehicle. The cloud-based battery diagnostic system also includes a processor configured to diagnose a battery status of the vehicle using collected current data and collected past data stored during a predetermined period of time, in response to determining that abnormality diagnostic information is included in the collected past data. The cloud-based battery diagnostic system additionally includes a storage configured to store data and algorithms executable by the processor.

## Description

### CROSS-REFERENCE TO RELATED APPLICATION

This application claims priority to and the benefit of Korean Patent Application No. 10-2024-0189557, filed on December 18, 2024, the entire contents of which are hereby incorporated herein by reference.

### BACKGROUND

### (a) Technical Field

The present disclosure relates to a cloud-based battery diagnostic system and a method therefor.

### (b) Description of the Related Art

Eco-friendly vehicles that use electric energy as a power source, such as electric vehicles and hybrid vehicles, are equipped with batteries that store and output electric energy. Such a battery includes a plurality of battery modules, and each of the battery modules may be formed of a plurality of battery cells.

Due to battery structure, performance dispersion between cells, and differences in deterioration, voltage differences occur between battery cells. voltage differences reduce the power that the battery can provide.

As such, in a case where battery damage occurs unexpectedly due to the voltage differences between cells, a driver may have difficulty driving the vehicle because the driver cannot anticipate battery damage in advance.

### SUMMARY

Embodiments of the present disclosure provide a cloud-based battery diagnostic system and method, capable of diagnosing a status of a battery in the cloud by detecting whether there is an abnormality in a battery onboard a vehicle and transmitting abnormality information to a cloud-based battery diagnostic apparatus.

Furthermore, embodiments of the present disclosure provide cloud-based battery diagnostic system and method, capable of diagnosing battery abnormality in detail by utilizing past time series data collected on in the cloud.

The technical objects of the present disclosure are not limited to the objects mentioned above. Other technical objects not mentioned herein should be more clearly understood by those having ordinary skill in the art from the description following description.

According to an embodiment of the present disclosure, a cloud-based battery diagnostic system is provided. The cloud-based battery diagnostic system includes a communication interface configured to collect data from a vehicle and transmit a battery status diagnostic result to the vehicle. The cloud-based battery diagnostic system also includes a processor configured to diagnose a battery status of the vehicle using collected current data and collected past data stored during a predetermined period of time in response to determining that abnormality diagnostic information is included in the collected past data collected. The cloud-based battery diagnostic system additionally includes a storage configured to store data and algorithms executable by the processor.

In an embodiment of the present disclosure, the processor may be configured to, based on determining that the abnormality diagnostic information is not included in the data collected from the vehicle, diagnose the battery status of the vehicle based on the collected current data.

In an embodiment of the present disclosure, the processor may be configured to classify the data collected from the vehicle according to one or more driving statuses of the vehicle, and to diagnose the battery status of the vehicle based on one or more algorithms corresponding to the one or more driving statuses.

In an embodiment of the present disclosure, the processor may be configured to link the collected current data and the collected past data stored during the predetermined period of time on a time series basis, and to diagnose the battery status of the vehicle based on the linked current and past data.

In an embodiment of the present disclosure, the processor may be configured to diagnose the battery status of the vehicle based on a battery model-based algorithm or an artificial intelligence (AI)-based algorithm.

In an embodiment of the present disclosure, the processor may be configured to, based on determining that battery performance of the vehicle is predicted to deteriorate based on a battery status diagnostic result, transmit, to the vehicle, an instruction to provide guidance to a user.

In an embodiment of the present disclosure, the processor may be configured to, based on determining that abnormal aging or abnormality has occurred inside a battery of the vehicle based on a battery status diagnostic result of the vehicle, transmit, to the vehicle, a control strategy for managing the battery status of the vehicle.

In an embodiment of the present disclosure, the processor may be configured to, based on determining that additional detailed diagnosis through self-diagnosis is necessary based on a battery status diagnostic result of the vehicle, transmit a self-diagnosis command to the vehicle.

In an embodiment of the present disclosure, the processor may be configured to, based on diagnosis a failure based on a battery status diagnostic result of the vehicle, transmit, to the vehicle, an instruction to limit use of a battery of the vehicle.

In an embodiment of the present disclosure, the cloud-based battery diagnostic system may further include a battery control apparatus for the vehicle. The battery control apparatus may be configured to collect data of the vehicle, detect a battery status based on the collected data, and transmit of detection of the battery status to the battery diagnostic apparatus.

In an embodiment of the present disclosure, the battery control apparatus is configured to analyze the collected data based on a diagnostic algorithm to produce a diagnostic result value, and, based on determining that the diagnostic result value exceeds a first reference value, determine that an abnormality has occurred in a battery of the vehicle.

In an embodiment of the present disclosure, the battery control apparatus is configured to transmit data including abnormality diagnosis information to the battery diagnostic apparatus based on determining that the abnormality has occurred in the battery of the vehicle.

In an embodiment of the present disclosure, the battery diagnostic apparatus is configured to determine that a failure has occurred based on determining that a result value of diagnosing the battery status of the vehicle exceeds a second reference value that is greater than the first reference value.

In an embodiment of the present disclosure, the battery diagnostic apparatus is configured to execute one or more algorithms for diagnosing the battery status of the vehicle and output a result value of diagnosing the battery status of the vehicle for each of the one or more algorithms. The one or more algorithms may correspond to respective ones of one or more driving statuses of the vehicle. The battery diagnostic apparatus may be configured to determine a failure response measure based on battery status diagnostic results of the vehicle, output for each of the at one or more algorithms.

According to another embodiment of the present disclosure, a battery diagnostic method is provided. The battery diagnostic method includes collecting, by a processor, data from a vehicle and diagnosing, by the processor, a battery status of the vehicle using currently collected data and past data stored during a predetermined period of time in response to determining that abnormality diagnostic information is included in the data collected from the vehicle. The battery diagnostic method also includes transmitting, by the processor, a battery status diagnostic result to the vehicle.

In an embodiment of the present disclosure, the battery diagnostic method may further include diagnosing, by the processor, the battery status of the vehicle based on the collected current data based on determining that abnormality diagnostic information is not included in the data collected from the vehicle.

In an embodiment of the present disclosure, diagnosing the battery status of the vehicle may include classifying, by the processor, the data collected from the vehicle according to one or more driving statuses of the vehicle, and diagnosing the battery status of the vehicle based on one or more algorithms corresponding to the one or more driving statuses.

In an embodiment of the present disclosure, diagnosing the battery status of the vehicle may further include linking, by the processor, the collected current data and past data stored during a predetermined period of time on a time series basis, and diagnosing, by the processor, the battery status of the vehicle based on the linked current and past data.

In an embodiment of the present disclosure, transmitting the battery status diagnostic result to the vehicle may include, based on determining that battery performance of the vehicle is predicted to deteriorate based on the battery status diagnostic result, transmitting, to the vehicle, an instruction for providing guidance to a user.

In an embodiment of the present disclosure, transmitting the battery status diagnostic result to the vehicle may include, based on determining that abnormal aging or abnormality has occurred inside a battery of the vehicle based on a battery status diagnostic result of the vehicle, transmitting, to the vehicle, a control strategy for managing the battery status of the vehicle.

According to embodiments of the present disclosure, it may be possible to detect a battery abnormality on board a vehicle and transmit battery abnormality information to a cloud-based battery diagnostic apparatus, so as to enable a detailed cloud-based diagnosis of a battery status, thereby increasing an efficiency of battery status diagnosis.

Furthermore, according to embodiments of the present disclosure, it may be possible to increase accuracy of battery status diagnosis by diagnosing a battery abnormality in detail using past time series data collected on a cloud basis.

Furthermore, various effects that may be directly or indirectly identified through the present specification may be provided.

### BRIEF DESCRIPTION OF THE DRAWINGS

FIG. 1 illustrates a block diagram showing an example configuration of a cloud-based battery diagnostic system, according to an embodiment.
FIGS. 2A and 2B illustrate views for describing an example failure diagnostic reference of a vehicle battery control apparatus, according to an embodiment.
FIGS. 3A-3C illustrate views for describing an example failure diagnostic reference of a vehicle battery control apparatus, according to an embodiment.
FIG. 4A illustrates an example of currently collected data, according to an embodiment.
FIG. 4B illustrates an example diagram of long-term data linking current data and past data, according to an embodiment.
FIG. 5 illustrates a flowchart showing a diagnostic process of a vehicle battery control apparatus prior to cloud-based battery diagnosis, according to an embodiment.
FIG. 6 illustrates a flowchart showing an example battery diagnostic method for a cloud-based battery diagnostic apparatus, according to an embodiment.
FIG. 7 illustrates a flowchart showing an example method for diagnosing a battery status using cloud-based currently collected data, according to an embodiment.
FIG. 8 illustrates a flowchart for describing an example method for diagnosing a battery status using cloud-based historical data, according to an embodiment.
FIG. 9 illustrates a flowchart for describing an example response action based on a cloud-based battery status diagnostic result, according to an embodiment.
FIG. 10 illustrates an example computing system, according to an embodiment.

### DETAILED DESCRIPTION

Hereinafter, embodiments of the present disclosure are described in detail with reference to the accompanying drawings. It should be noted that in adding reference numerals to constituent elements of each drawing, the same constituent elements are designated with the same reference numerals even when the elements are displayed on different drawings. In the present disclosure, where it was determined that a detailed description of the well-known configuration or function may obscure the gist of the present disclosure, the detailed description thereof has been omitted.

In describing constituent elements according to embodiments of the present disclosure, terms such as first, second, A, B, (a), and (b) may be used. These terms are only for distinguishing the constituent elements from other constituent elements, and the nature, sequences, or orders of the constituent elements are not limited by the terms. Furthermore, all terms used herein including technical scientific terms have the same meanings as those generally understood by those having ordinary skill in the art to which the present disclosure pertains unless differently defined herein. Terms defined in a generally used dictionary should be construed to have meanings matching those in the context of the related art, and should not be construed to have idealized or excessively formal meanings unless the terms are clearly defined in the present specification.

In the present disclosure, when a component, controller, device, element, apparatus, unit or the like of the present disclosure is described as having a purpose or performing an operation, function, or the like, the component, controller, device, element, apparatus, unit or the like should be considered herein as being "configured to" meet that purpose or to perform that operation or function. Each component, controller, device, element, apparatus, unit, and the like may separately embody or be included with a processor and a memory, such as a non-transitory computer readable media, as part of the apparatus.

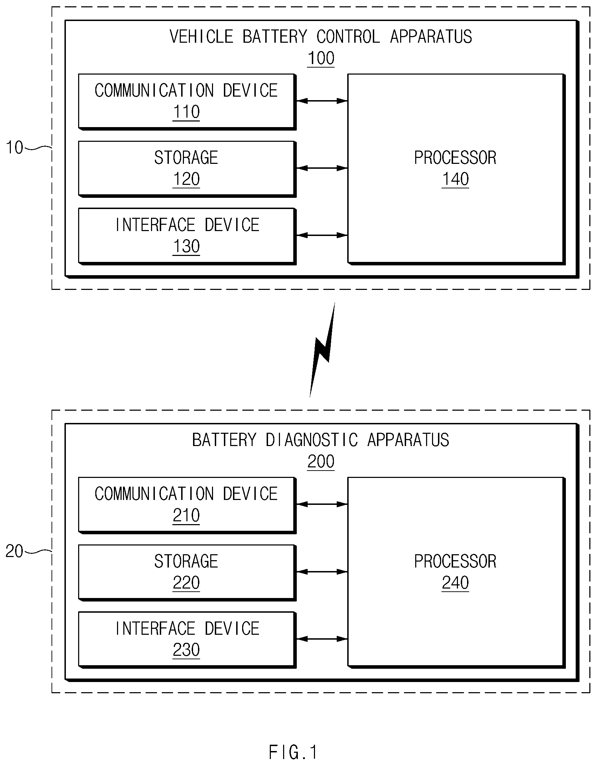

Hereinafter, embodiments of the present disclosure are described in detail with reference to FIGS. 1-10.

FIG. 1 illustrates a block diagram showing an example configuration of a cloud-based battery diagnostic system, according to an embodiment.

Referring to FIG. 1, a battery diagnostic system according to an embodiment of the present disclosure may include a vehicle battery control apparatus 100 for a vehicle 10 and a battery diagnostic apparatus 200 for a cloud server 20.

According to an embodiment of the present disclosure, the battery control apparatus 100 may be implemented within or separately from a vehicle. For example, the battery control apparatus 100 may be integrally formed with internal control units of the vehicle, or may be implemented as a separate hardware device to be connected to control units of the vehicle by a connection means. In various examples, the battery control apparatus 100 may be implemented integrally with the vehicle, may be implemented in a form that is installed or attached to the vehicle as a configuration separate from the vehicle, or a part of the battery control apparatus 100 may be implemented integrally with the vehicle and another part of the battery control apparatus 100 may be implemented in a form that is installed or attached to the vehicle as a configuration separate from the vehicle.

The battery control apparatus 100 may be configured to collect data of the vehicle 10, detect a battery status based on the collected data, and transmit the battery status to the battery diagnosis apparatus 200. In an embodiment, the data of the vehicle 10 may include data collected during driving, data collected during parking, data collected during charging, etc.

The battery control apparatus 100 may include a communication device 110, a storage 120, an interface device 130, and a processor 140. According to an embodiment of the present disclosure, the battery control apparatus 100 may be implemented as a single device with the components 110-140 coupled with each other. In some embodiments, one or more of the components 110-140 may be omitted.

The communication device 110 may be a hardware device implemented with various electronic circuits to transmit and receive signals through a wireless or wired connection, and may transmit and receive information based on in-vehicle devices and in-vehicle network communication techniques. In an embodiment of the present disclosure, the in-vehicle network communication techniques may include Controller Area Network (CAN) communication, Local Interconnect Network (LIN) communication, flex-ray communication, and/or the like. The communication device 110 may exchange (transmit and receive) information with internal devices such as vehicles, ships, airplanes, urban air mobilities (UAM), and electric kickboards based on the network communication techniques.

The communication device 110 may perform V2X communication. The V2X communication may include communication between vehicle and other entities such as V2V (vehicle-to-vehicle) communication, which refers to communication between vehicles, V2I (vehicle to infrastructure) communication, which refers to communication between a vehicle and an eNB or road side unit (RSU), V2P (vehicle-to-pedestrian) communication, which refers to communication between user equipment (UE) held by vehicles and individuals (pedestrians, cyclists, vehicle drivers, or occupants), and V2N (vehicle-to-network) communication.

Furthermore, the communication device 110 may include a mobile communication module, a wireless Internet module, a short-range communication module, etc. for communication with the battery diagnostic apparatus outside the vehicle.

The mobile communication module may be configured to perform communication using technical standards or communication methods for mobile communication (e.g., Global System for Mobile communication (GSM), Code Division Multi access (CDMA), Code Division Multi Access 2000 (CDMA 2000), Enhanced Voice-Data Optimized or Enhanced Voice-Data Only (EV-DO), Wideband CDMA (WCDMA), High Speed Downlink Packet Access (HSDPA), High Speed Uplink Packet Access (HSUPA), Long Term Evolution (LTE), Long Term Evolution-Advanced (LTE-A), 4th Generation mobile telecommunication (4G), 5th Generation mobile telecommunication (5G), etc.

The wireless Internet module may be a module for wireless Internet access, and may be configured to perform communication through Wireless LAN (WLAN), Wireless-Fidelity (Wi-Fi), Wi-Fi direct, Digital Living Network Alliance (DLNA), Wireless Broadband (WiBro), World Interoperability for Microwave Access (WiMAX), High Speed Downlink Packet Access (HSDPA), High Speed Uplink Packet Access (HSUPA), Long Term Evolution (LTE), Long Term Evolution-Advanced (LTE-A), etc.

The short-range communication module may support short-range communication by using at least one of Bluetooth^{™} radio frequency identification (RFID), infrared data association (IrDA), ultra wideband (UWB), ZigBee, near field communication (NFC), a wireless universal serial bus (USB) technique, or any combination thereof.

In an embodiment, the communication device 110 may be configured to transmit a first battery diagnostic result to the battery diagnostic apparatus 200 and receive a second battery diagnostic result from the battery diagnostic apparatus 200. Furthermore, the communication device 110 may be configured to transmit data to the cloud server 20 using a central communication unit (CCU) or an audio, video, navigation, and telecommunication (AVNT).

The storage 120 may store data and/or algorithms required for the processor 140 to operate, and the like. For example, the storage 120 may store data and algorithms for diagnosing a battery status.

The storage 120 may include a storage medium of at least one type among memories of types such as a flash memory, a hard disk, a micro, a card (e.g., a secure digital (SD) card or an extreme digital (XD) card), a random access memory (RAM), a static RAM (SRAM), a read-only memory (ROM), a programmable ROM (PROM), an electrically erasable PROM (EEPROM), a magnetic memory (MRAM), a magnetic disk, and/or an optical disk.

The interface device 130 may include an input means for receiving a control command from a user and an output means for outputting an operation state of the apparatus 100 and results thereof. In various embodiments, the input means may include a key button, a mouse, a joystick, a jog shuttle, a stylus pen, and/or the like. In some embodiments, the input means may include a soft key implemented on the display.

The interface device 130 may be implemented as a head-up display (HUD), a cluster, an audio video navigation (AVN), a human machine interface (HM), and/or the like.

The output device may include a display and/or a voice output means such as a speaker. In an embodiment in which a touch sensor formed of a touch film, a touch sheet, or a touch pad is provided on the display, the display may operate as a touch screen, and may be implemented in a form in which an input device and an output device are integrated. In embodiments of the present disclosure, the output device may be configured to output a battery status diagnostic result and output an action (e.g., slow charging, SOC usage range restriction, control strategy according to a battery status, a self-diagnosis mode, etc.) according to the battery status diagnostic result.

In various embodiments, the display may include at least one of a liquid crystal display (LCD), a thin film transistor liquid crystal display (TFT LCD), an organic light emitting diode display (OLED display), a flexible display, a field emission display (FED), and/or a 3D display.

The processor 140 may be electrically connected to the communication device 110, the storage 120, the interface unit 130, etc. and may be configured to perform overall control such that each component may normally perform its function. Furthermore, the processor 140 may be an electrical circuit that may be configured to electrically control each component, and to execute a command of software, thereby performing various data processing and calculations described herein.

The processor 140 may be implemented in the form of hardware, software, or a combination of hardware and software. The processor 140 may be implemented as a microprocessor, but the present disclosure is not limited thereto. In various examples, the processor 140 may be a part of, e.g., an electronic control unit (ECU), a micro controller unit (MCU), or other sub-controllers mounted in the vehicle.

The processor 140 may be implemented with an application specific integrated circuit (ASIC), a digital signal processor (DSP), a programmable logic device (PLD), a field programmable gate array (FPGA), a central processing unit (CPU), a microcontroller, a microprocessor and/or the like.

The processor 140 may be configured to collect data of the vehicle, detect a battery status based on the collected data, and transmit the battery status to the battery diagnostic apparatus.

The processor 140 may be configured to analyze the collected data based on a diagnostic algorithm to produce a diagnostic result value. In an embodiment, the processor 140 may be configured to, in response determining that the diagnostic result value exceeds a first predetermined reference value, determine that an abnormality has occurred in a battery of the vehicle.

In an embodiment, the processor 140 may be configured to diagnose the battery status in advance using the first reference value that is lower than a reference value during general failure diagnosis.

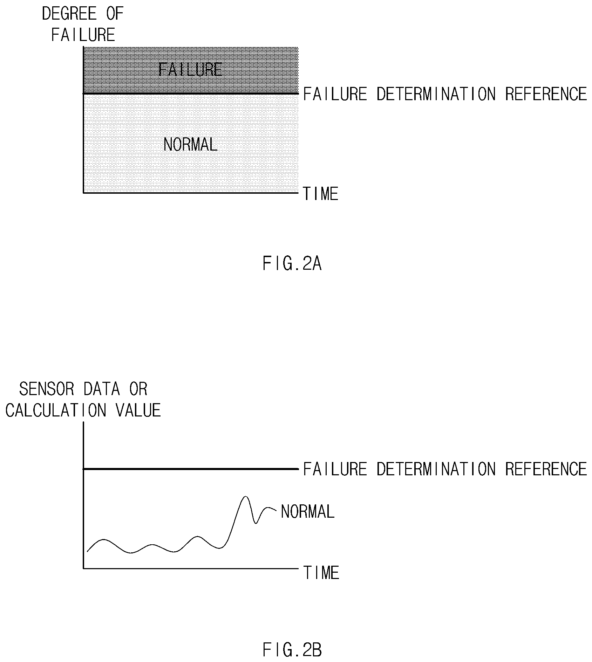

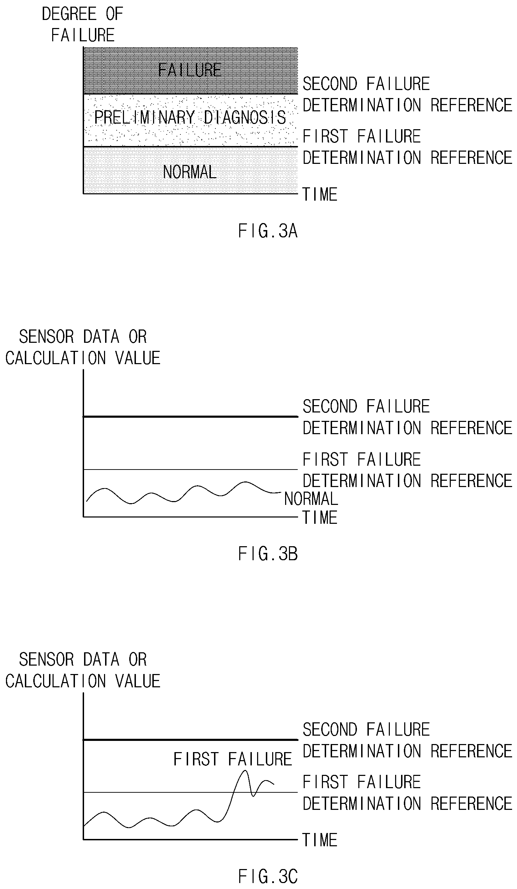

Referring to FIGS. 2A and 2B, in an embodiment, there is one reference for failure diagnosis, and in this case, preliminary diagnosis may be difficult. Accordingly, in an embodiment, a first failure determination reference and a second failure determination reference may be set as shown in FIGS. 3A-C. FIGS. 2A and 2B illustrate views for describing an example failure diagnostic reference of a vehicle battery control apparatus. FIGS. 3A-C illustrate views for describing an example of more detailed failure diagnostic reference of a vehicle battery control apparatus.

In an embodiment, the second fault determination reference may be identical to one of the criteria of FIG. 2A for failure diagnosis. However, the first failure determination reference that is lower than the second failure determination reference may be additionally set.

Accordingly, according to an embodiment of the present disclosure, the first failure determination reference before a second failure determination reference for fault diagnosis may be used in a vehicle to determine in advance a risk of occurrence of an abnormal status or failure. In FIG. 3B, an example is illustrated in which a sensor value or a calculation value (diagnostic result value) by a diagnostic algorithm is determined to be normal because the diagnostic result value is lower than the first failure determination reference. In FIG. 3C, an example is illustrated in which a sensor value or a calculation value (diagnostic result value) by a diagnosis algorithm is determined to be abnormal because the diagnostic result value exceeds the first failure determination reference. In various embodiments, the sensor value may indicate a value such as a temperature, a voltage, or a current sensed by a sensing device (not shown).

Accordingly, in response to determining that there is a problem with the vehicle's battery, the processor 140 may be configured to transmit data including abnormality diagnostic information to the battery diagnostic apparatus 200. Accordingly, the battery diagnostic apparatus 200 may be configured to perform more detailed battery diagnosis.

In response to receiving a battery status diagnostic result from the battery diagnosis apparatus 200, the processor 140 may be configured to perform a response measure according to the battery status diagnostic result.

For example, failure-related response measures may be divided into passive mitigation, active mitigation, self-diagnosis, and failure diagnosis.

The processor 140 may be configured to guide a user on slow charging, a SOC usage range suggestion, etc. in a case of a passive mitigation measure. The processor 140 may be configured to provide guidance through user terminals, clusters, app push, etc.

The processor 140 may be configured to wirelessly update a control strategy optimized for a battery status in response to determining that an active mitigation measure is required.

In response to receiving a self-diagnosis command from the battery diagnostic apparatus 200, the processor 140 may be configured to additionally diagnose the battery status in detail through self-diagnosis and transmit a self-diagnostic result to the battery diagnostic apparatus 200.

In a case where the battery status is determined to be in a failure state by the battery diagnostic apparatus 200, the processor 140 may be configured to perform charging amount limitation, output limitation, or induce the vehicle to be brought to an AS center.

Furthermore, the battery diagnostic apparatus 200 for the cloud server 20 may be configured to collect data from the vehicle battery control apparatus 100 for the vehicle 10, diagnose the battery status in detail, and transmit a result of the battery diagnosis to the vehicle 10.

The battery diagnostic apparatus 200 may include a communication device 210, a storage 220, an interface device 230, and a processor 240. According to an embodiment of the present disclosure, the battery diagnostic apparatus 200 may be implemented as a single device with the components 210-240 coupled with each other. In some embodiment, one or more of the components 210-240 may be omitted.

The communication device 210 may be a hardware device implemented with various electronic circuits to transmit and receive signals through wireless or wired connections, and may be configured to perform communication with the vehicle 10. For example, the communication device 210 may be configured to receive data (first failure diagnostic result) from the vehicle 10 and transmit a battery diagnostic result of the vehicle 10 analyzed by the processor 240 to the vehicle 10.

Furthermore, the communication device 210 may include a mobile communication module, a wireless Internet module, a short-range communication module, etc. for communication with the vehicle 10.

The mobile communication module may be configured to perform communication using technical standards or communication methods for mobile communication (e.g., Global System for Mobile communication (GSM), Code Division Multi access (CDMA), Code Division Multi Access 2000 (CDMA 2000), Enhanced Voice-Data Optimized or Enhanced Voice-Data Only (EV-DO), Wideband CDMA (WCDMA), High Speed Downlink Packet Access (HSDPA), High Speed Uplink Packet Access (HSUPA), Long Term Evolution (LTE), Long Term Evolution-Advanced (LTE-A), 4th Generation mobile telecommunication (4G), 5th Generation mobile telecommunication (5G), etc.

The wireless Internet module may be a module for wireless Internet access, and may be configured to perform communication through Wireless LAN (WLAN), Wireless-Fidelity (Wi-Fi), Wi-Fi direct, Digital Living Network Alliance (DLNA), Wireless Broadband (WiBro), World Interoperability for Microwave Access (WiMAX), High Speed Downlink Packet Access (HSDPA), High Speed Uplink Packet Access (HSUPA), Long Term Evolution (LTE), Long Term Evolution-Advanced (LTE-A), etc.

The short-range communication module may support short-range communication by using at least one of Bluetooth^{™} radio frequency identification (RFID), infrared data association (IrDA), ultra wideband (UWB), ZigBee, near field communication (NFC), a wireless universal serial bus (USB) technique, or any combination thereof.

The storage 220 may store data and/or algorithms required for the processor 240 to operate, and the like.

For example, the storage 120 may be configured to store data collected from the vehicle 10 during a predetermined period of time and store data for each past driving condition. Furthermore, the storage 120 may be configured to store a battery status diagnostic algorithm for each driving condition, a battery model, a data-based model, a rule-based diagnostic algorithm, a model-based diagnosis algorithm, a data-driven diagnosis algorithm, an Al-based diagnostic algorithm with a large amount of computations, etc.

The storage 220 may include a storage medium of at least one type among memories of types such as a flash memory, a hard disk, a micro, a card (e.g., a secure digital (SD) card or an extreme digital (XD) card), a random access memory (RAM), a static RAM (SRAM), a read-only memory (ROM), a programmable ROM (PROM), an electrically erasable PROM (EEPROM), a magnetic memory (MRAM), a magnetic disk, and/or an optical disk.

The interface device 230 may include an input means for receiving a control command from a user and an output means for outputting an operation state of the apparatus 200 and results thereof. In various embodiments, the input means may include a key button, a mouse, a joystick, a jog shuttle, a stylus pen, and/or the like. In some embodiments, the input means may include a soft key implemented on the display.

The output device may include a display and/or may a voice output means such as a speaker. In an embodiment in which a touch sensor formed of a touch film, a touch sheet, or a touch pad is provided on the display, the display may operate as a touch screen, and may be implemented in a form in which an input device and an output device are integrated. In embodiments of the present disclosure, the output device may output a result of diagnosing a battery status based on current data and past data.

In various embodiments, the display may include at least one of a liquid crystal display (LCD), a thin film transistor liquid crystal display (TFT LCD), an organic light emitting diode display (OLED display), a flexible display, a field emission display (FED), and/or a 3D display.

The processor 240 may be electrically connected to the communication device 210, the storage 220, the interface unit 230, etc. and may be configured to perform overall control such that each component may normally perform its function. Furthermore, the processor 240 may be an electrical circuit that may be configured to electrically control each component, and to execute a command of software, thereby performing various data processing and calculations described herein.

The processor 240 may be implemented in the form of hardware, software, or a combination of and software. The processor 240 may be implemented as a microprocessor, but the present disclosure is not limited thereto. For example, the processor 240 may be implemented with an application specific integrated circuit (ASIC), a digital signal processor (DSP), a programmable logic device (PLD), a field programmable gate array (FPGA), a central processing unit (CPU), a microcontroller, a microprocessor and/or the like.

In response to determining that abnormality diagnostic information is included in the data collected from the vehicle 10, the processor 240 may be configured to diagnose a battery status of the vehicle using the collected current data and past data stored during a predetermined period of time.

In response to determining that the data collected from the vehicle 10 does not include abnormality diagnostic information, the processor 240 may be configured to diagnose the battery status of the vehicle based on the currently collected data.

The processor 240 may be configured to classify data collected from the vehicle 10 according to one or more driving statuses of the vehicle and diagnose the battery status of the vehicle 10 based on one or more algorithms corresponding to the one or more driving statuses. In an embodiment, an algorithm for each driving status may include a battery model-based algorithm or an Al-based algorithm.

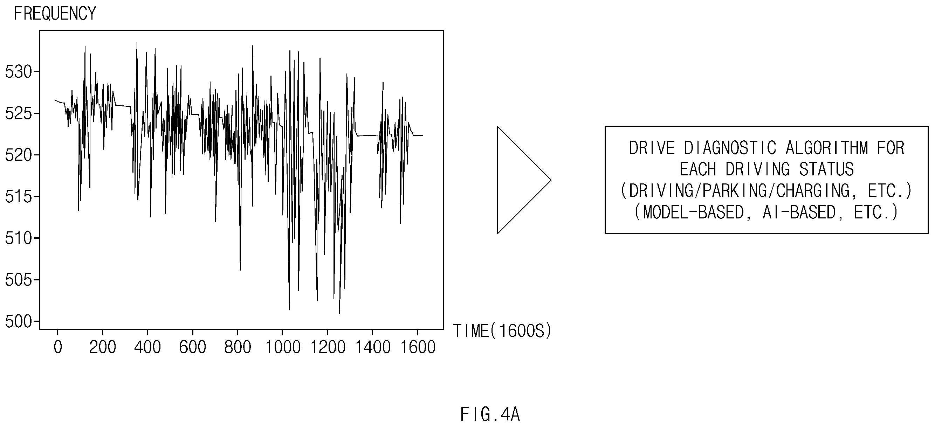

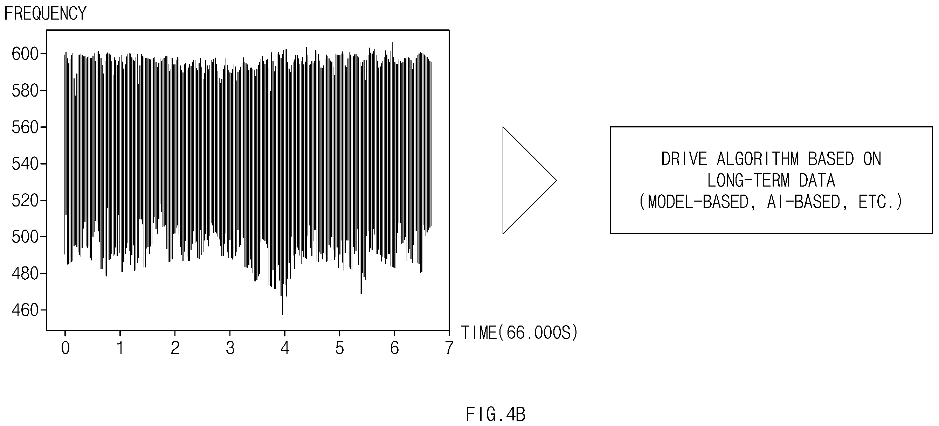

The processor 240 may be configured to link the currently collected data and the past data stored during a predetermined period of time on a time series basis and diagnose the battery status of the vehicle based on the linked current data and past data. In an embodiment, the collected current data is as shown in FIG. 4A, and the long-term data linking the current data and the past data is as shown in FIG. 4B.

In response to determining that battery performance of the vehicle is predicted to deteriorate in the future based on a battery status diagnostic result, the processor 240 may be configured to control the vehicle to provide guidance to a user.

In response to determining that abnormal aging or abnormality has occurred inside a battery of the vehicle based on the battery status diagnostic result of the vehicle, the processor 240 may be configured to provide (e.g., transmit) to the vehicle a control strategy for managing the battery status of the vehicle.

In response to determining that additional detailed diagnosis through self-diagnosis is necessary based on the battery status diagnostic result of the vehicle, the processor 240 may be configured to provide (e.g., transmit) a self-diagnosis command to the vehicle.

In response diagnosing a failure based on the battery status diagnostic result of the vehicle, the processor 240 may be configured to provide (e.g., transmit) to the vehicle an instruction to implement a method for limiting use of the battery.

The processor 240 may be configured to determine that a failure has occurred in response to determining that the battery status diagnostic result of the vehicle exceeds a second reference (e.g., second failure determination reference of FIG. 3A) that is greater than a first reference (e.g., first failure determination reference of FIG. 3A).

The processor 240 may be configured to execute one or more algorithms for diagnosing the battery status of the vehicle and output a result value of diagnosing the battery status of the vehicle for each of the one or more algorithms. The one or more algorithms may correspond to respective ones of one or more driving statuses (e.g., driving, parking, and charging) of the vehicle. The processor 240 may be configured to determine a failure response measure based on battery status diagnostic results of the vehicle, output for each of the one or more algorithm.

As such, according to embodiments of the present disclosure, by performing a first diagnosis (pre-diagnosis) on the vehicle and requesting a second diagnosis (detailed diagnosis) to the cloud server 20, cloud computing resources of the cloud server 20 and long-term stored past time series data may be used to diagnose the battery status in detail, thereby enabling a more precise diagnosis of the battery status by the vehicle.

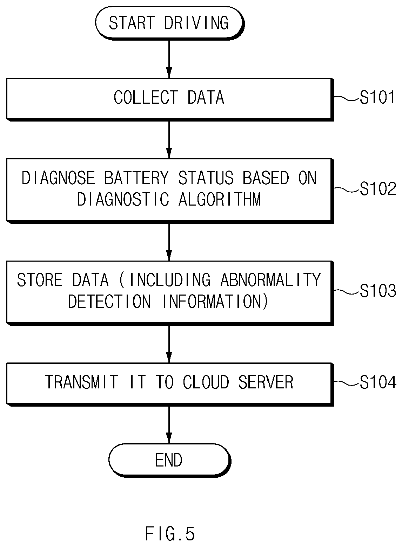

Hereinafter, a method for diagnosing a battery of a vehicle according to an embodiment of the present disclosure is described with reference to FIGS. 5-9. FIG. 5 illustrates a flowchart showing a diagnostic process of a vehicle battery control apparatus prior to cloud-based battery diagnosis, according to an embodiment.

Hereinafter, it is assumed that the battery control apparatus 100 for the vehicle 10 illustrated in FIG. 1 performs processes of FIG. 5. Furthermore, in the description of FIG. 5, operations described as being performed by a device may be understood as being controlled by the processor 140 of the battery control apparatus 100. In example embodiments, operations S101-S104 may be performed sequentially, but are not necessarily performed sequentially. For example, an order of the operations may be changed and/or at least two operations may be performed in parallel.

Referring to FIG. 5, in an operation S101, the battery control apparatus 100 may collect data in response to a case where the vehicle starts driving. The battery control apparatus 100 may be configured to collect data even when the vehicle is not driving. In an embodiment, the data may include vehicle signals (e.g., a cumulative driving distance, a charging status, etc.) and battery management system (BMS) signals (e.g., a battery voltage, a battery current, a battery temperature, a battery SOC, etc.) as raw data.

In an operation S102, the battery control apparatus 100 may diagnose a status of the battery based on a diagnostic algorithm. In various embodiments, the diagnostic algorithm may include a rule-based diagnostic algorithm, a model-based diagnostic algorithm, a data-driven diagnostic algorithm, etc. In an embodiment, the rule-based diagnostic algorithm, the model-based diagnostic algorithm, and the data-driven diagnostic algorithm may be common diagnostic algorithms, and their detailed descriptions have been omitted.

In some embodiments, it may be difficult to install a complex or computationally intensive diagnostic algorithm in the battery control apparatus 100 within the vehicle. Accordingly, in an embodiment, the battery control apparatus 100 within the vehicle 10 may be configured to perform a first diagnosis based on a simple diagnostic algorithm and request a second diagnosis from the cloud server 20 for battery diagnosis using a more precise diagnostic algorithm. The first diagnosis may correspond to a preliminary diagnosis and the second diagnosis may correspond to a detailed diagnosis.

In an operation S103, the battery control apparatus 100 may store resulting data in response to determining that the battery status is diagnosed based on the diagnostic algorithm. The result data may include abnormality detection information output during a first diagnosis process.

In an operation S104, the battery control apparatus 100 may transmit the result data including abnormality detection information to the cloud server 20.

The battery control apparatus 100 for the vehicle 10 may have limitations in memory capacity and driving performance for diagnosis using all algorithms and all long-term time series data, and a risk of actual failure may be low, so it may be inefficient to store complex and computationally intensive algorithms and a large amount of data in the vehicle 10.

Accordingly, in embodiments of the present disclosure, the battery control apparatus 100 for the vehicle 10 may be configured to initially diagnose the battery status using a small amount of computation algorithm and current data and transmit a result thereof to the cloud server 20.

Accordingly, a battery diagnosis efficiency may be increased by detecting more than one condition on board the vehicle and performing the second diagnosis of the battery status using long-term time series data collected from the cloud server 20.

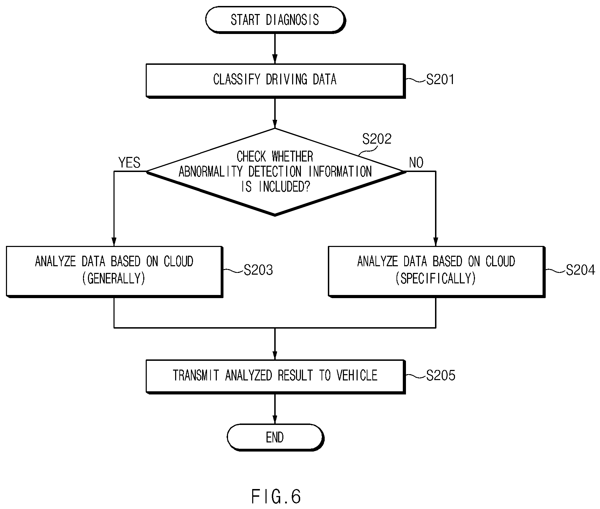

Hereinafter, it is assumed that the battery diagnostic apparatus 200 for the cloud server 20 of FIG. 1 performs the processes of FIGS. 6-9. In addition, in the description of FIGS. 6-9, operations described as being performed by the device may be understood as being controlled by the processor 240 of the battery diagnostic apparatus 200. In following example embodiments, the illustrated operations may be performed sequentially, but are not necessarily performed sequentially. For example, an order of the operations may be changed and/or at least two operations may be performed in parallel.

FIG. 6 illustrates a flowchart showing an example battery diagnostic method for a cloud-based battery diagnostic apparatus, according to an embodiment.

Referring to FIG. 6, in an operation S201, the battery diagnostic apparatus 200 may classify data collected from the vehicle 10. In an embodiment, the battery diagnostic apparatus 200 may be configured to classify the collected data according to driving status (e.g., driving, parking, and charging).

In an operation S202, the battery diagnostic apparatus 200 may be configured to check whether the data collected from the vehicle 10 includes abnormality detection information. In an operation S203, in response to determining that the abnormality detection information is not included, the battery diagnostic apparatus 200 may diagnose the battery status by analyzing the current data using the current data based on the cloud.

On the other hand, in response to determining that the data collected from the vehicle 10 includes abnormality detection information, the battery diagnostic apparatus 200 may analyze the data and diagnose the battery status using not only current data but also past data based on the cloud in an operation S204.

In an operation S205, the battery diagnostic apparatus 200 may transmit a result of diagnosing the battery status to the vehicle 10.

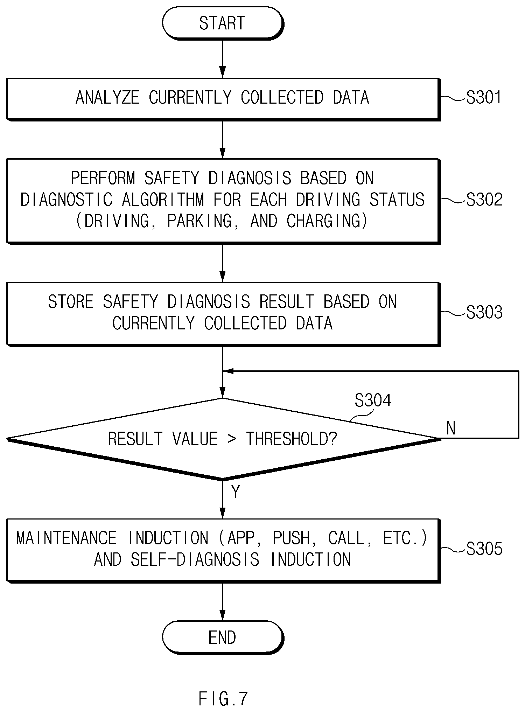

FIG. 7 illustrates a flowchart showing an example method for diagnosing a battery status using cloud-based currently collected data, according to an embodiment. FIG. 7 illustrates the operation S203 of FIG. 6 in more detail, according to an embodiment.

Referring to FIG. 7, the battery diagnostic apparatus 200 may be configured to diagnose the battery status using the currently collected data because the abnormality detection information is not included in the data collected from the vehicle 10.

In an operation S301, the battery diagnostic apparatus 200 may first start analyzing the currently collected data, and, in an operation S302, may perform a safety diagnosis of the battery status based on a diagnostic algorithm for each driving status. In other words, the algorithm for diagnosing the battery status may be classified by driving condition, and may include a driving algorithm, a parking algorithm, a charging algorithm, etc. In an embodiment, the driving status algorithm may operate on the driving status data classified in the operation S201 of FIG. 6. For example, the driving algorithm may be driven by data collected during driving, the parking algorithm may be driven by data collected during parking, and the charging algorithm may be driven by data collected during charging.

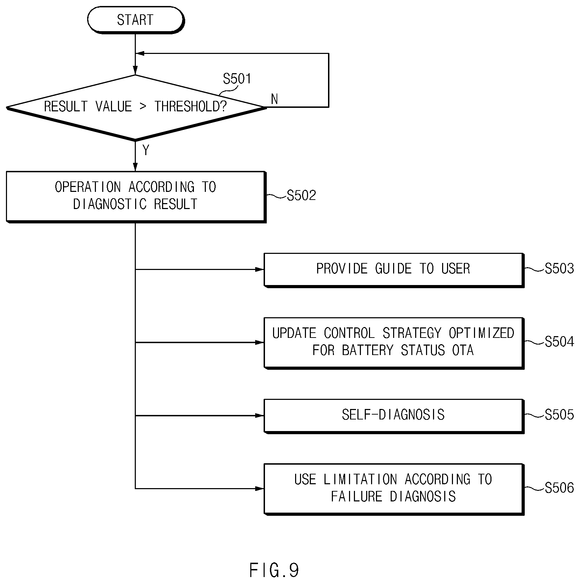

In an operation S303, the battery diagnostic apparatus 200 may store a battery status diagnostic result obtained by diagnosing it based on the currently collected data. In an operation S304, the battery diagnostic apparatus 200 may determine whether the battery status diagnostic result value diagnosed based on the currently collected data is greater than a predetermined threshold. In an operation S305, in response to determining in the operation S304 that the battery status diagnostic result value is greater than the threshold, the battery diagnostic apparatus 200 may determine a failure-related response measure and transfer it to the vehicle 10. In an embodiment, the failure-related response measures may include maintenance induction, update, self-diagnosis induction, usage restriction, etc.. Failure-related response measures, according to an embodiment, are described in more detail below with reference to FIG. 9. The vehicle 10 may output a response plan related to a failure through an app push, phone call, cluster, etc., so that a user may check it.

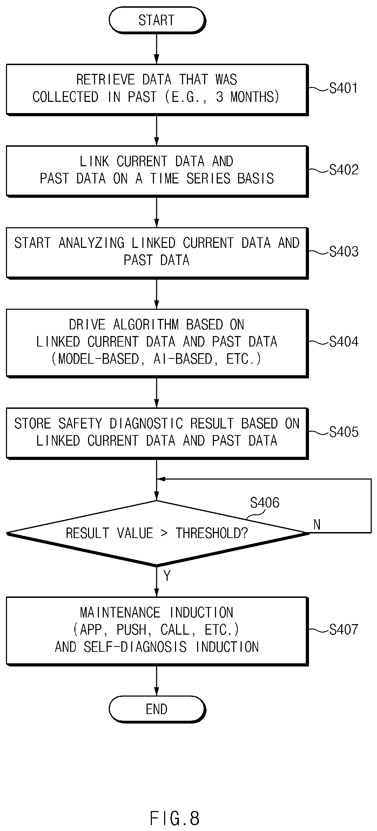

FIG. 8 illustrates a flowchart for describing an example method for diagnosing a battery status using cloud-based historical data, according to an embodiment. FIG. 8 illustrates the operation S204 of FIG. 6 in more detail, according to an embodiment.

Referring to FIG. 8, in an operation S401, the battery diagnostic apparatus 200 may retrieve data that was collected and stored in the past.

In an operation S402, the battery diagnostic apparatus 200 may link current data and past data on a time series basis.

In an embodiment, the current data may be data for 1600 seconds as shown in FIG. 4A and data obtained by linking the current data and the past data may be data for 66000 seconds as shown in FIG. 4B. The cloud server 20 may thus be configured to diagnose the battery status using a large amount of data over a long period of time, thereby increasing accuracy of the battery status diagnostic result.

Inn an operation S403, the battery diagnostic apparatus 200 may analyze the linked current data and past data. In an operation S404, the battery diagnostic apparatus 200 may diagnose the battery status by executing an algorithm based on the linked current data and past data. In an embodiment, the algorithm based on the linked current and past data may be a model-based algorithm or an Al-based algorithm that may analyze massive data.

In an operation S405, the battery diagnosis apparatus 200 may operate an algorithm based on the linked current data and past data to store the diagnosed battery status diagnostic result. In an operation S406, the battery diagnostic apparatus 200 may determine whether a diagnostic result value is greater than a predetermined threshold. In an operation S407, in response to determining in the operation S406 that the diagnostic result value is greater than the threshold, the battery diagnosis apparatus 200 may determine a failure-related response measure and transmit it to the vehicle 10. In an embodiment, the failure-related response measures may include maintenance induction, update, self-diagnosis induction, usage restriction, etc. The failure-related response measure, according to an embodiment, is described in more detail below with reference to FIG. 9. The vehicle 10 may output a response plan related to a failure through an app push, phone call, cluster, etc., so that a user may check it.

FIG. 9 illustrates a flowchart for describing an example response action based on a cloud-based battery status diagnostic result, according to an embodiment.

Referring to Fig. 9, in an operation S501, the battery diagnostic apparatus 200 may determine whether a battery status diagnostic result value (second diagnosis) is greater than a predetermined threshold.

In an operation S502, the battery diagnostic apparatus 200 may be configured to determine a failure-related response measure and transmit it to the vehicle 10 in response determining that the battery status diagnostic result value is greater than the predetermined threshold.

In an embodiment, such failure-related response measures may be divided into passive mitigation, active mitigation, self-diagnosis, and failure diagnosis.

The battery diagnostic apparatus 200 may be configured to perform the passive mitigation by determining that battery performance may deteriorate in the future in response to determining that an abnormality may occur inside the battery based on the battery status diagnostic result using a battery model or a data-based model. In an embodiment, the passive mitigation may include providing guidance to a user on slow charging, SOC usage range suggestion, etc.

Furthermore, the battery diagnostic apparatus 200 may perform the active mitigation by determining that the battery performance has deteriorated and requires management in response to a case where abnormal aging or abnormality occurs inside the battery as a result of the battery status diagnosis using the battery model or the data-based model. In an embodiment, the active mitigation may include a response such as updating a control strategy optimized for the battery status over-the-air (OTA).

Furthermore, the battery diagnostic apparatus 200 may be configured to perform final determination of the battery status after detailed diagnosis in the vehicle 10 by transmitting a detailed self-diagnosis command to the vehicle 10 in response to determining that detailed additional diagnosis is necessary as a result of the battery status diagnosis using the battery model or the data-based model.

Furthermore, the battery diagnostic apparatus 200 may be configured to determine a battery usage restriction such as a charging amount limit, an output limit, etc. in response to a case where a failure is determined by utilizing the battery model or the data-based model, and may be configured to induce the vehicle to be brought to an AS center.

As such, according to embodiments of the present disclosure, the battery control apparatus 100 for the vehicle may be configured to perform the first diagnosis of the battery status using a relatively simple algorithm and current data, transmit a result thereof to the cloud server 20, and perform the detailed second diagnosis on the cloud server 20, so the vehicle 10 may respond based on a diagnostic result of the cloud server 20, thereby increasing reliability of the battery status.

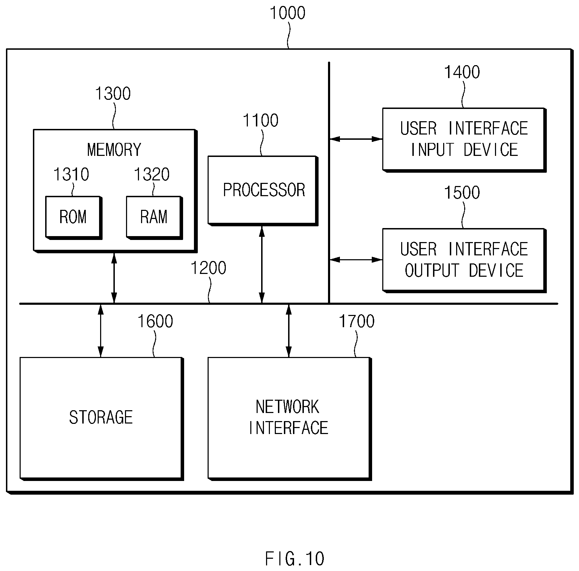

FIG. 10 illustrates an example computing system that may be configured to implement various devices, operations, processes, methods, etc. described herein, according to an embodiment.

Referring to FIG. 10, the computing system 1000 includes at least one processor 1100 connected through a bus 1200, a memory 1300, a user interface input device 1400, a user interface output device 1500, and a storage 1600, or a network interface 1700.

The processor 1100 may be a central processing unit (CPU) or a semiconductor device that performs processing on commands stored in the memory 1300 and/or the storage 1600. The memory 1300 and the storage 1600 may include various types of volatile or nonvolatile storage media. For example, the memory 1300 may include a read only memory (ROM) 1310 and a random access memory (RAM) 1320.

Accordingly, steps of a method or algorithm described in connection with embodiments included herein may be directly implemented by hardware, a software module, or a combination of the two, executed by the processor 1100. The software module may reside in a storage medium (e.g., the memory 1300 and/or the storage 1600) such as a RAM memory, a flash memory, a ROM memory, an EPROM memory, an EEPROM memory, a register, a hard disk, a removable disk, and a CD-ROM.

The storage medium is coupled to the processor 1100, which can read information from and write information to the storage medium. Alternatively, the storage medium may be integrated with the processor 1100. The processor and the storage medium may reside within an application specific IC (ASIC). The ASIC may reside within a user terminal. Alternatively, the processor and the storage medium may reside as separate components within the user terminal.

The above description is merely illustrative of the technical idea of the present disclosure, and those having ordinary skill in the art to which the present disclosure pertains may make various modifications and variations without departing from the essential characteristics of the present disclosure.

Therefore, the embodiments described in the present disclosure are not intended to limit the technical ideas of the present disclosure, but to explain them, and the scope of the technical ideas of the present disclosure is not limited by the described embodiments. The protection range of the present disclosure should be interpreted by the claims below, and all technical ideas within the equivalent range should be interpreted as being included in the scope of the present disclosure.

## Claims

1. A cloud-based battery diagnostic system including a battery diagnostic apparatus, the cloud-based battery diagnostic system comprising:
a communication device configured to collect data from a vehicle and transmit a battery status diagnostic result to the vehicle;
a processor configured to diagnose a battery status of the vehicle using collected current data and collected past data stored during a predetermined period of time, based on determining that abnormality diagnostic information is included in the collected past data; and
a storage configured to store data and algorithms executable by the processor.

2. **The** cloud-based battery diagnostic system of claim 1, wherein the processor is configured to, based on determining that the abnormality diagnostic information is not included in the collected past data, diagnose the battery status of the vehicle based on the collected current data.

3. **The** cloud-based battery diagnostic system of claim 1 or 2, wherein the processor is configured to:
classify the data collected from the vehicle according to one or more driving statuses of the vehicle; and
diagnose the battery status of the vehicle based on one or more algorithms corresponding to the one or more driving statuses.

4. **The** cloud-based battery diagnostic system of anyone of claims 1-3, wherein the processor is configured to:
link the collected current data and the collected past data stored during the predetermined period of time on a time series basis; and
diagnose the battery status of the vehicle based on the linked current and past data.

5. **The** cloud-based battery diagnostic system of anyone of claims 1-4, wherein the processor is configured to diagnose the battery status of the vehicle based on a battery model-based algorithm or an artificial intelligence (AI)-based algorithm.

6. **The** cloud-based battery diagnostic system of anyone of claims 1-5, wherein the processor is configured to, based on determining that battery performance of the vehicle is predicted to deteriorate based on a battery status diagnostic result, transmit, to the vehicle, an instruction to provide guidance to a user.

7. **The** cloud-based battery diagnostic system of anyone of claims 1-6, wherein the processor is configured to, based on determining that abnormal aging or abnormality has occurred inside a battery of the vehicle based on a battery status diagnostic result of the vehicle, transmit, to the vehicle, a control strategy for managing the battery status of the vehicle.

8. **The** cloud-based battery diagnostic system of anyone of claims 1-7, wherein the processor is configured to, based on determining that additional detailed diagnosis through self-diagnosis is necessary based on a battery status diagnostic result of the vehicle, transmit a self-diagnosis command to the vehicle.

9. **The** cloud-based battery diagnostic system of anyone of claims 1-8, wherein the processor is configured to, based on diagnosing a failure based on a battery status diagnostic result of the vehicle, transmit, to the vehicle, an instruction to limit use of a battery of the vehicle.

10. **The** cloud-based battery diagnostic system of anyone of claims 1-9, further comprising a battery control apparatus for the vehicle, the battery control apparatus configured to:
collect data of the vehicle;
detect a battery status based on the collected data; and
transmit a result of detection of the battery status to the battery diagnostic apparatus.

11. **The** cloud-based battery diagnostic system of claim 10, wherein the battery control apparatus is configured to:
analyze the collected data based on a diagnostic algorithm to produce a diagnostic result value; and
based on determining that the diagnostic result value exceeds a first reference value, determine that an abnormality has occurred in a battery of the vehicle.

12. **The** cloud-based battery diagnostic system of claim 11, wherein the battery control apparatus is configured to transmit data including abnormality diagnosis information to the battery diagnostic apparatus based on determining that the abnormality has occurred in the battery of the vehicle.

13. **The** cloud-based battery diagnostic system of claim 11 or 12, wherein the battery diagnostic apparatus is configured to determine that a failure has occurred based on determining that a result value of diagnosing the battery status of the vehicle exceeds a second reference value that is greater than the first reference value.

14. **The** cloud-based battery diagnostic system of claim 13, wherein the battery diagnostic apparatus is configured to:
execute one or more algorithms for diagnosing the battery status of the vehicle and output a result value of diagnosing the battery status of the vehicle for each of the one or more algorithms, wherein the one or more algorithms correspond to respective ones of one or more diving statuses of the vehicle; and
determine a failure response measure based on battery status diagnostic results of the vehicle, output for each of the one or more algorithms.

15. A battery diagnostic method comprising:
collecting, by a processor, data from a vehicle;
diagnosing, by the processor, a battery status of the vehicle using currently collected data and past data stored during a predetermined period of time, in response to determining that abnormality diagnostic information is included in the data collected from the vehicle; and
transmitting, by the processor, a battery status diagnostic result to the vehicle.
